# EUROPÄISCHE PATENTSCHRIFT

(11) **EP 3 868 021 B1**
(45) Veröffentlichungstag und Bekanntmachung des Hinweises auf die Patenterteilung: **19.10.2022**
(21) Anmeldenummer: 19829206.2
(22) Anmeldetag: 20.12.2019
(51) Int. Cl.: H03K 17/082, H02H 3/02

(54) **ELEKTRONISCHER SCHALTER**
ELECTRONIC SWITCH
COMMUTATEUR ÉLECTRONIQUE

(30) Priorität: 31.01.2019 EP 19154820
(43) Veröffentlichungstag der Anmeldung: 25.08.2021
(73) Patentinhaber: Siemens Aktiengesellschaft, 80333 München (DE)
(72) Erfinder: SCHIERLING, Hubert, 91052 Erlangen (DE)
(86) Internationale Anmeldenummer: PCT/EP2019/086730
(87) Internationale Veröffentlichungsnummer: WO 2020/156747

(56) Entgegenhaltungen:
- EP-A1- 3 327 886
- EP-A2- 2 017 934
- FR-A- 1 575 029

## Beschreibung

Die Erfindung betrifft einen elektronischen Schalter, wobei der elektronische Schalter einen Halbleiterschalter, einen ersten verbraucherseitigen Anschluss, einen ersten quellenseitigen Anschluss und einen zweiten quellenseitigen Anschluss aufweist, wobei der Halbleiterschalter zwischen dem ersten quellenseitigen Anschluss und dem ersten verbraucherseitigen Anschluss angeordnet ist. Ferner betrifft die Erfindung ein elektrisches Netz mit einer Energiequelle und mindestens einem derartigen elektronischen Schalter. Die Erfindung betrifft weiter ein Verfahren zum Betreiben eines derartigen elektronischen Schalters oder eines derartigen elektrischen Netzes.

In elektrischen Netzen kommen vermehrt elektronische Schalter auf der Basis von Halbleitern zum Schalten von Strömen und damit zum Schutz von elektrischen Verbrauchern zum Einsatz. Diese elektronischen Schalter weisen dabei einen Halbleiterschalter auf. Da diese dem Schutz der Komponenten in elektrischen Netzen dienen, werden diese elektronischen Schalter auch als Schutzorgan bezeichnet. Neben dem Halbleiterschalter können diese Schutzorgane u.a. auch noch eine Ansteuerschaltung und Schutzeinrichtungen, beispielsweise zum Schutz vor einer Überspannung, aufweisen.

Dabei werden die elektronischen Schalter häufig zwischen einer Energiequelle und einem elektrischen Verbraucher oder einer Gruppe von elektrischen Verbrauchern angeordnet. Damit kann ein einzelner elektrischer Verbraucher oder ein ganzer Abgang mit seinen Verbrauchern geschützt werden.

Wenn ein solcher elektronischer Schalter trotz eines Abschaltbefehls die Verbindung nicht auftrennt, so bleibt der Abzweig mit den angeschlossenen Verbrauchern oder der betreffende elektrische Verbraucher unter Spannung.

Dieser Fall kann durch Messung, beispielsweise durch eine Strommessung oder eine Spannungsmessung, am elektronischen Schalter erkannt, aber nicht verhindert werden.

Ein elektronischer Schalter nach dem Oberbegriff von Anspruch 1 ist in EP2017934 A2 offenbart. Der Erfindung liegt die Aufgabe zugrunde, einen elektronischen Schalter hinsichtlich seines Abschaltverhaltens im Fehlerfall zu verbessern.

Diese Aufgabe wird durch einen elektronischen Schalter gelöst, wobei der elektronische Schalter einen Halbleiterschalter, einen ersten verbraucherseitigen Anschluss, einen ersten quellenseitigen Anschluss und einen zweiten quellenseitigen Anschluss aufweist, wobei der Halbleiterschalter zwischen dem ersten quellenseitigen Anschluss und dem ersten verbraucherseitigen Anschluss angeordnet ist, wobei zwischen dem ersten verbraucherseitigen Anschluss und dem zweiten quellenseitigen Anschluss ein Schalter angeordnet ist, wobei der Halbleiterschalter derart ausgebildet ist, durch Auswirkung eine thermische Überlastung im Innern des Halbleiterschalters nichtreversibel in den geöffneten Zustand überzugehen, wobei der Schalter dazu eingerichtet ist, die thermische Überlastung durch Schließen des Schalters und sich damit ausbildenden Kurzschlussstrom zu erzeugen, wobei der Schalter als Thyristor ausgebildet ist.

Diese Aufgabe wird ferner durch ein elektrisches Netz mit einer Energiequelle und mindestens einem derartigen elektronischen Schalter gelöst, wobei der erste quellenseitige Anschluss und der zweite quellenseitige Anschluss des elektronischen Schalters mit der Energiequelle verbunden sind. Weiter wird diese Aufgabe durch ein Verfahren zum Betreiben eines derartigen elektronischen Schalters oder eines derartigen elektrischen Netzes gelöst, wobei der Schalter geschlossen wird, wenn der Halbleiterschalter und/oder der weitere Halbleiterschalter abgeschaltet wird.

Weitere vorteilhafte Ausgestaltungen der Erfindung sind in den abhängigen Ansprüchen angegeben.

Der Erfindung liegt die Erkenntnis zugrunde, dass sich ein elektronischer Schalter dadurch verbessern lässt, indem in den elektronischen Schalter ein Schalter integriert wird. Bei diesem Schalter kann es sich um einen mechanischen Schalter oder um einen Schalter auf Basis eines Halbleiters handeln. Dieser Schalter wird so angeordnet, dass bezüglich des ersten und des zweiten quellenseitigen Anschlusses, der Halbleiterschalter und der Schalter in einer Reihenschaltung angeordnet sind. Dabei kann diese Reihenschaltung noch weitere Elemente zwischen dem ersten und dem zweiten quellenseitigen Anschluss aufweisen. Insbesondere können, allerdings nicht notwendigerweise, auch zwischen dem Schalter und dem zweiten quellenseitigen Anschluss eine oder mehrere weitere Komponenten angeordnet sein. Als Beispiel ist hier ein weiterer Halbleiterschalter zu nennen.

Unter einer Reihenschaltung wird das serielle Anordnen von Bauelementen verstanden, wobei sich die Spannungen an den einzelnen Bauelementen addieren. Somit sind auch die Komponenten einer Sternschaltung als Reihenschaltungen zu betrachten, auch wenn am Sternpunkt ein Abzweig vorhanden ist, so dass die Komponenten nicht zwangsweise vom gleichen Strom durchflossen werden.

Sofern die quellenseitigen Anschlüsse mit einer Energiequelle verbunden sind, bildet sich durch Schließen des Schalters bei gleichzeitig geschlossenem Halbleiterschalter ein Kurzschlussstrom aus, der den Halbleiterschalter derart durch einen zu hohen Strom überlastet, dass der Halbleiterschalter in einen geöffneten Zustand übergeht. Der geöffnete Zustand wird auch als nichtleitender Zustand bezeichnet.

Am Markt sind verschiedene Halbleiterschalter verfügbar, bei denen eine Überlastung durch einen zu hohen Strom zu einer sperrenden Wirkung des Halbleiterschalters führt. Das heißt, der Halbleiterschalter geht in den geöffneten Zustand, auch als nichtleitender Zustand bezeichnet, über. Dies kann beispielsweise dadurch geschehen, dass in einem Halbleitermodule vorhandene Bonddrähte durch den zu hohen Strom thermisch überlastet werden und schmelzen. Dadurch kann keine leitende Verbindung am Halbleiterschalter mehr hergestellt werden und der Halbleiterschalter geht damit sicher und dauerhaft in den geöffneten Zustand über. Halbleiterschalter in Modulbauweise sind sehr kompakt aufgebaut und verwenden für die elektrische Kontaktierung in der Regel Bonddrähte.

Falls der Halbleiterschalter sich aufgrund einer Störung nicht öffnen lässt, d.h. nicht mittels eines Ansteuersignals in den nichtleitenden Zustand überführen lässt, können die verbraucherseitigen Anschlüsse nicht spannungsfrei geschaltet werden. Damit können der oder die an den verbraucherseitigen Anschlüssen angeschlossenen Verbraucher oder ein dort angeschlossenes Teilnetz nicht mehr zuverlässig geschützt werden, da ein Abschalten der Energieversorgung der Energiequelle nicht mehr möglich ist. Dieser Zustand kann auf verschiedene Arten, beispielsweise mittels Sensoren wie einem Stromsensor oder einem Spannungssensor, zuverlässig erkannt werden. Bei Erkennung des Fehlers kann dann der Schalter geschlossen werden. Der entstehende Kurzschlussstrom, der von der Energiequelle getrieben wird, verändert den Halbleiterschalter so, dass dieser in den geöffneten Zustand übergeht. Dabei kann der Schalter bei jedem Öffnen des Halbleiterschalters eingeschaltet werden oder nur wenn eine Fehlfunktion wie ein Abschaltversagen des Halbleiterschalters erkannt wird. Sofern der Halbleiterschalter wie vorgesehen öffnet, hat der Schalter keine Wirkung auf den Halbleiterschalter. Bei einem Schaltversagen sorgt er jedoch dafür, dass der Halbleiterschalter sicher abschaltet, indem er durch den Überstrom in den geöffneten Zustand übergeht. Dabei kann der Schalter gleichzeitig mit Abschalten des Halbleiterschalters geschlossen werden oder zeitlicher Versatz vorgesehen werden. Mit einem zeitlichen Versatz lässt sich unter anderem die Belastung von Halbleiterschalter und mechanischen Schalter verringern.

Es gibt verschiedene Methoden, ein Schaltversagen des Halbleiterschalters zu erkennen. Ein Versagen kann beispielsweise durch eine im Halbleiterschalter vorhandene Logik erkannt werden. Die Elektronik des Halbleiterschalters überwacht dabei die Spannung des Halbleiterschalters (z.B. Auswertung der Spannungsmessung vor und hinter dem Schalter) und/oder den Strom durch den Halbleiterschalter. Wenn trotz Abschaltbefehls weiterhin Strom fließt bzw. die Spannung über dem Schalter über eine vorgegebene Zeit, beispielsweise in der Größenordnung von Sekunden, im Bereich der Durchlassspannung bleibt, liegt ein Fehler vor. Wenn der Schalter geöffnet wird, muss die Spannung auf der Lastseite absinken, weil dort vorhandene Kondensatoren entladen werden; bei einer Entladezeit von 5 min sind dies typischerweise etwa 10 V in 5 Sekunden. Alternativ kann ein Schaltversagen auch durch eine externe Überwachung, die die Signale des Schalters (Strom, Spannung) auswertet oder eine getrennte Messwerterfassung nutzt, erkannt werden.

Dabei kann der Schalter in einer Baueinheit mit dem Halbleiterschalter angeordnet sein. Darüber hinaus kann diese Baueinheit zusätzlich auch die Ansteuerschaltung für den Halbleiterschalter umfassen. Damit kann auch eine Logik in diese Baueinheit integriert werden, bei der der Schalter nur schließt, falls eine Fehlfunktion des Halbleiterschalters erkannt wird.

Der Schalter ist als Thyristor ausgebildet. In einem Beispiel, das nicht in den Ansprüchen enthalten ist, ist der Schalter als mechanischer oder Leistungshalbleiter ausgebildet.

Ein mechanischer Schalter ist preisgünstig am Markt verfügbar. Er besitzt die Fähigkeit, große Ströme zu führen, ohne dabei thermisch zu überlasten. Seine im Vergleich zu Halbleiterschaltern langsame Schaltzeit kann toleriert werden, da auch ein zeitlicher Versatz zwischen dem Ausschalten des Halbleiterschalters und dem Einschalten des Schalters für die Funktion ausreichend ist. Ebenso ist es möglich, einen Leistungshalbleiter einzusetzen. Dieser besitzt eine vergleichbare oder sogar identische Ansteuerung wie der Halbleiterschalter, so dass dieser einfach herstellbar ist. Insbesondere bietet sich ein Thyristor an. Dieser hat eine hohe Stromtragfähigkeit und auch eine gute kurzfristige Überlastbarkeit zum Führen des Kurzschlussstromes. Sein Nachteil, einen Strom nicht abschalten zu können, fällt nicht ins Gewicht, da der Strom durch den Übergang zum nichtleitenden Zustand des Halbleiterschalters zum Erliegen kommt.

Bei einer weiteren vorteilhaften Ausgestaltung der Erfindung weist der elektronische Schalter einen weiteren Halbleiterschalter und einen zweiten verbraucherseitigen Anschluss auf, wobei der weitere Halbleiterschalter zwischen dem zweiten quellenseitigen Anschluss und dem zweiten verbraucherseitigen Anschluss angeordnet ist. Damit lässt sich ein an den verbraucherseitigen Anschlüssen angeschlossenes Teilnetz oder Verbraucher mehrpolig, insbesondere zweipolig bei der Verwendung von zwei Halbleiterschaltern, von der Energiequelle trennen. Damit ist der abgeschaltete Teil dann potentialfrei, so dass er auch beispielsweise geerdet werden kann. Gerade für ein Gleichspannungsnetz als elektrisches Netz ist die zweipolige Abschaltung mit zwei Halbleiterschaltern positiv, da dieses Netz genau zwei Potentiale und damit zwei elektrische Leiter umfasst. Allerdings lässt sich diese Anordnung auch auf mehrere Leiter erweitern. So können zum Beispiel mit drei Halbleiterschaltern ein elektronischer Schalter für die drei Phasen eines Drehstromnetzes realisiert werden.

Bei einer weiteren vorteilhaften Ausgestaltung der Erfindung ist der Schalter zwischen dem ersten verbraucherseitigen Anschluss und dem zweiten verbraucherseitigen Anschluss angeordnet. Mit dieser Schaltung lässt sich ein sicheres Abschalten bei einer Schaltung mit zwei Halbleiterschaltern, d.h. dem Halbleiterschalter und dem weiteren Halbleiterschalter, auf einfache Weise realisieren. Bei dieser Ausgestaltung befindet sich der Schalter zwischen den beiden Halbleiterschaltern. Wenn beide Halbleiterschalter ordnungsgemäß abschalten, ist der Schalter ohne Wirkung. Auch wenn nur einer der beiden Halbleiterschalter ordnungsgemäß funktioniert, können die verbraucherseitigen Anschlüsse des elektronischen Schalters spannungsfrei, jedoch nicht potentialfrei geschaltet werden. Erst bei einem Fehler in beiden Halbleiterschaltern, bei denen beide nicht abschalten, führt der Schalter zu einem Kurzschlussstrom durch die beiden Halbleiterschalter, der zumindest einen der beiden Halbleiterschalter dauerhaft wie oben beschrieben in den geöffneten Zustand versetzt. Dadurch kann auf einfache Weise eine Redundanz erreicht werden, da der elektronische Schalter auch bei Abschaltversagen beider Schalter noch die verbraucherseitigen Anschlüsse spannungsfrei schalten kann. Durch die Redundanz erhöht sich die Zuverlässigkeit des elektronischen Schalters. Somit kann ohne zusätzliche Logik die Sicherheit des elektronischen Schalters mit zwei Halbleiterschaltern durch nur einen Schalter auf einfache Weise sichergestellt werden.

Bei einer weiteren vorteilhaften Ausgestaltung der Erfindung ist das elektrische Netz als Gleichspannungsnetz oder Wechselspannungsnetz, insbesondere als Drehstromnetz, ausgebildet. Gerade das Abschalten eines Gleichstroms ist für mechanische Schalter schwierig, da in diesem Fall ein entstehender Lichtbogen zum Löschen zu bringen ist. Elektronische Schalter eignen sich in diesem Falle besonders zum Schalten von Gleichstrom, da aufgrund der Verwendung des Halbleiterschalters im Gegensatz zu mechanischen Schaltern ein solcher Lichtbogen nicht entsteht. Damit kann auf die Verwendung eines weiteren Schutzelements, das gerade für die Anwendung im Gleichspannungsnetzen teuer und/oder verlustbehaftet ist, verzichtet werden. Somit lässt sich durch den elektronischen Schalter ein schneller, zuverlässiger und gleichzeitig kostengünstiger Schutz der verbraucherseitig angeschlossenen Teilnetze und/oder Verbraucher erzielen.

Darüber hinaus ist der elektronische Schalter auch für die Anwendung in einem elektrischen Netz geeignet, das als Wechselspannungsnetz, insbesondere als Drehstromnetz, ausgebildet ist. Mit dem Halbleiterschalter lassen sich kurze Schaltzeiten realisieren, die unabhängig von einem Nulldurchgang des Stromes sind. Somit eignen sich diese elektronischen Schalter für jede Art von Wechselspannungsnetz, insbesondere sowohl für 50Hz, 60Hz wie auch 16 2/3 Hz Anwendungen. In diesen Netzen können entsprechende Lasten, beispielsweise besonders gegenüber Überströmen empfindliche Lasten oder Teilnetze, schnell und zuverlässig von der Energiequelle getrennt und damit vor unzulässig hohen Strömen wie Kurzschlussströmen geschützt werden.

Bei einer weiteren vorteilhaften Ausgestaltung der Erfindung weist das elektrische Netz mindestens einen elektrischen Verbraucher auf. Der elektronische Schalter eignet sich insbesondere aufgrund seiner schnellen Reaktionszeit zum Schutz des oder der verbraucherseitig angeschlossenen elektrischen Verbraucher. Diese können damit besonders im Fehlerfall, bei dem ein zu hoher Strom den Verbraucher schädigen oder zerstören kann, eine Belastung durch einen zu hohen Strom verhindern. Gerade in Gleichspannungsnetzen kann die Induktivität aufgrund nicht vorhandener Transformatoren gering sein. Diese geringe Induktivität erhöht die Stromanstiegsgeschwindigkeit im Fehlerfall, so dass gerade auch in Gleichspannungsnetzen in kurzer Zeit für den Verbraucher unzulässig hohe Ströme entstehen. Diese werden durch den elektronischen Schalter mittels des Halbleiterschalters verhindert, da dieser entsprechend schnell abschalten kann, bevor unzulässig hohe Stromwerte erreicht werden.

Bei einer weiteren vorteilhaften Ausgestaltung der Erfindung erfolgt das Schließen des Schalters zeitgleich oder mit einem zeitlichen Verzug zum Zeitpunkt des Abschaltens des Halbleiterschalters und/oder des weiteren Halbleiterschalters. Das Schließen des Schalters kann ohne zeitlichen Verzug zum Abschalten des Halbleiterschalters oder der Halbleiterschalter durchgeführt werden. Durch die schnelle Reaktion des Halbleiterschalters wird ein Kurzschlussstrom zuverlässig verhindert. Gleichzeitig wird auch bei Abschaltversagen des Halbleiterschalters, der Halbleiterschalter oder einer der Halbleiterschalter ein schneller Schutz erreicht, da durch gleichzeitiges Schließen des Schalters und dem dann entstehenden Kurzschlussstrom der Halbleiterschalter oder mindestens einer der Halbleiterschalter schnell in den geöffneten, d.h. nichtleitenden Zustand, gebracht wird.

Ebenso ist es möglich, insbesondere dann, wenn nur bei Vorliegen eines Fehlerfalls der Schalter geschlossen werden soll, einen zeitlichen Versatz zwischen Abschalten des Halbleiterschalters und Schließen des Schalters vorzusehen. Während dieser Zeitdauer des zeitlichen Verzugs kann ein Fehlverhalten des Schalters sicher erkannt und ein Schließen des Schalters veranlasst werden. Die Zeitdauer des zeitlichen Versatzes wird dann zur sicheren Fehlererkennung beispielsweise mittels eines Strom- oder Spannungssensors genutzt.

Bei einer weiteren vorteilhaften Ausgestaltung der Erfindung erfolgt das Schließen des Schalters, wenn ein Fehler des Halbleiterschalters und/oder des weiteren Halbleiterschalters erkannt wird. In diesem Fall wird der Schalter nur dann geschlossen, wenn ein Abschaltversagen des Halbleiterschalters und/oder des weiteren Halbleiterschalters vorliegt. Dies reduziert die Anzahl der Schalthandlungen des Schalters und erhöht damit die Lebensdauer des Schalters. Zudem kann für den Schalter ein Schalter mit nur einer geringen Anzahl von Schalthandlungen verwendet werden, der somit günstig am Markt verfügbar ist. Gerade der mechanische Schalter unterliegt bei seinem Schaltvorgang einem Verschleiß, der die Lebensdauer begrenzt. Somit eignet sich gerade für einen mechanischen Schalter diese Ausgestaltungsform.

Darüber hinaus bietet sich an, einen zeitlichen Versatz für das Einschalten des Schalters gegenüber dem Abschalten des Halbleiterschalters und/oder weiteren Halbleiterschalters vorzusehen. In dieser Zeitdauer kann ein Schaltversagen des Halbleiterschalters wie bereits oben beschrieben sicher erkannt werden und der Schalter eingeschaltet werden. Damit kann zuverlässig die Notwendigkeit für das Einschalten des Schalters erkannt und umgesetzt werden.

Im Folgenden wird die Erfindung anhand der in den Figuren dargestellten Ausführungsbeispiele näher beschrieben und erläutert. Es zeigen:
- FIG 1 bis FIG 3: Ausführungsbeispiele eines elektronischen Schalters,
- FIG 4 und FIG 5: Ausführungsbeispiele eines elektrischen Netzes und
- FIG 6: den zeitlichen Verlauf von Ansteuersignalen.

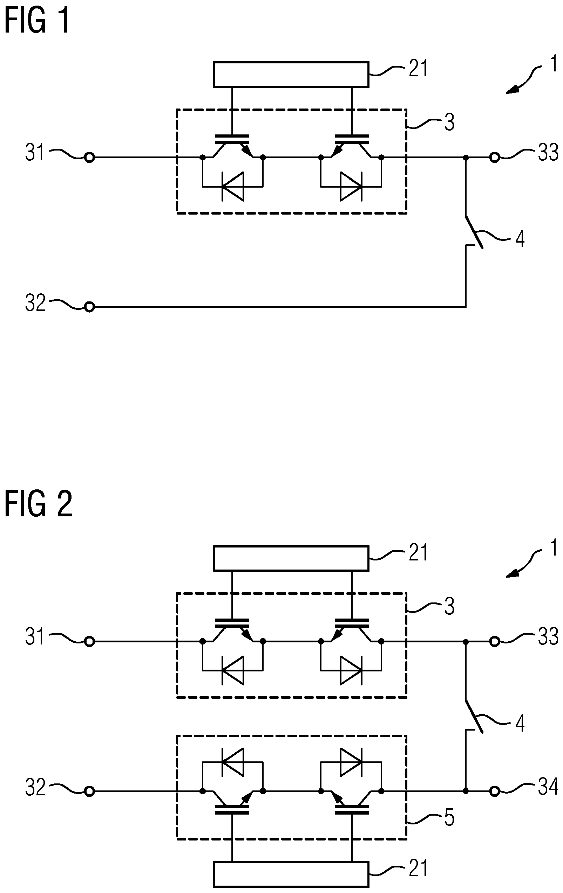

Die FIG 1 zeigt ein erstes Ausführungsbeispiel eines elektronischen Schalters 1. Dieser weist einen ersten quellenseitigen Anschluss 31, einen zweiten quellenseitigen Anschluss 32 und einen ersten verbraucherseitigen Anschluss 33 auf. Zwischen dem ersten quellenseitigen Anschluss 31 und dem ersten verbraucherseitigen Anschluss 33 ist ein Halbleiterschalter 3 angeordnet. Dieser umfasst in diesem Ausführungsbeispiel zwei einzelne Halbleiter, die jeweils Strom in eine Richtung schalten können, so dass der Halbleiterschalter Ströme in beiden Richtungen führen und schalten kann. Der Ansteuerung der beiden Halbleiter dient eine Ansteuerschaltung 21. Um ein sicheres Abschalten des elektronischen Schalters 1 auch bei einem Abschaltversagen des Halbleiterschalters 3 sicherzustellen, ist zwischen dem ersten verbraucherseitigen Anschluss 33 und dem zweiten quellenseitigen Anschluss 32 ein Schalter 4 angeordnet. Bei einem Abschaltversagen des Halbleiterschalters 3 wird der Schalter 4 geschlossen. Zwischen dem ersten und dem zweiten quellenseitigen Anschluss bildet sich ein von einer hier nicht dargestellten Energiequelle 7 getriebener Kurzschlussstrom aus, der den Halbleiterschalter 3 derart überlastet, dass dieser in den sperrenden, d.h. nichtleitenden Zustand übergeht. Dadurch wird eine sichere Trennung zwischen dem ersten quellenseitigen Anschluss 31 und dem ersten verbraucherseitigen Anschluss 33 hergestellt. Mit anderen Worten werden der erste quellenseitige Anschluss 31 und der erste verbraucherseitige Anschluss 33 elektrisch voneinander isoliert. Bei diesem elektronischen Schalter 1 handelt es sich um einen einpoligen Schalter.

Die FIG 2 zeigt ein Ausführungsbeispiel eines elektronischen Schalters 1 als zweipoligen Schalter. Zur Vermeidung von Wiederholungen wird auf die Beschreibung zur FIG 1 sowie auf die dort eingeführten Bezugszeichen verwiesen. Dieser elektronische Schalter 1 weist neben den zuvor eingeführten Anschlüssen einen zweiten verbraucherseitigen Anschluss 34 auf. Zwischen dem Schalter 4 und dem zweiten quellenseitigen Anschluss 32 ist nun ein weiterer Halbleiterschalter 5 angeordnet. Der Schalter 4 befindet sich zwischen dem ersten verbraucherseitigen Anschluss 33 und dem zweiten verbraucherseitigen Anschluss 34. Der weitere Halbleiterschalter 5 befindet sich zwischen dem zweiten quellenseitigen Anschluss 32 und dem zweiten verbraucherseitigen Anschluss 34. Dabei können der Halbleiterschalter 3 und der weitere Halbleiterschalter 5 die gleiche Ansteuerschaltung 21 nutzen oder, wie in dieser Figur dargestellt, mit unterschiedlichen Ansteuerschaltungen 21 verbunden sein. Bei einem Abschaltversagen von Halbleiterschalter 3 und weiterem Halbleiterschalter 5 bewirkt ein Schließen des Schalters 4 einen durch die hier nicht dargestellte Energiequelle 7 getriebenen Kurzschlussstrom, der zumindest einen der beiden Halbleiterschalter 3, 5 oder beide Halbleiterschalter 3, 5 in den nichtleitenden Zustand überführt und damit den elektronischen Schalter 1 öffnet.

Das Ausführungsbeispiel des zweipoligen elektronischen Schalters 1 nach FIG 2 eignet sich im Besonderen für die Anwendung in einem Gleichspannungsnetz, da dort die Energie mittels zwei Potentialen, zwischen denen eine Gleichspannung anliegt, übertragen wird. Ebenso ist der einpolige elektronische Schalter gemäß FIG 1 im Besonderen für die Anwendung in einem Gleichspannungsnetz geeignet, wenn es hinreichend ist, eine Spannungsfreiheit herzustellen. Dies ist beispielsweise dann der Fall, wenn die über den elektronischen Schalter miteinander verbundenen Teilnetze geerdet sind.

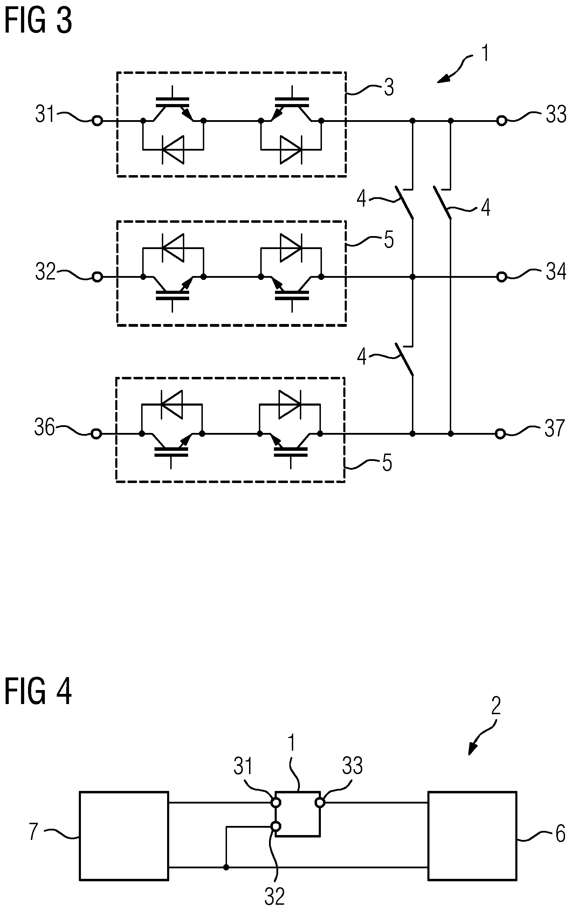

Die FIG 3 zeigt einen elektronischen Schalter für ein dreiphasiges Drehstromnetz als Beispiel für ein Wechselspannungsnetz. Zur Vermeidung von Wiederholungen wird auf die Beschreibung zu den Figuren 1 und 2 sowie auf die dort eingeführten Bezugszeichen verwiesen. Zur quellenseitigen und verbraucherseitigen Verbindung weist dieser elektronische Schalter 1 einen weiteren quellenseitigen Anschluss 36 und einen weiteren verbraucherseitigen Anschluss 37 auf. Dabei sind in dieser Anordnung drei Schalter 4 vorhanden und zwischen den verbraucherseitigen Anschlüssen 33, 34, 37 angeordnet. Dies kann beispielsweise, wie dargestellt, in einer Dreieckschaltung geschehen. Alternativ ist es auch möglich, die drei Schalter 4 eines Drehstromnetzes in einer Sternschaltung anzuordnen. Sobald die Halbleiterschalter 3, 5 öffnen, können die Schalter 4 geschlossen werden. Das kann zeitgleich oder mit einem zeitlichen Versatz geschehen. Sofern mindestens zwei der drei Halbleiterschalter 3, 5, öffnen ist die Energieübertragung zwischen den quellenseitigen Anschlüssen 31, 32, 36 zu den verbraucherseitigen Anschlüssen 33, 34, 37 unterbrochen. Sofern bei zwei oder sogar allen drei Halbleiterschaltern 3, 5 ein Abschaltversagen vorliegt, wird über mindestens einen der Schalter 4 ein Kurzschlussstrom generiert, der dazu führt, dass im ungünstigsten Fall bis auf einen der Halbleiterschalter 3, 5 die übrigen Halbleiterschalter 3,5 in den geöffneten Zustand übergehen. Damit ist die Energieübertragung durch den elektronischen Schalter 1 sicher unterbrochen.

Die FIG 4 zeigt ein Ausführungsbeispiel eines elektrischen Netzes 2. Dabei kann es sich um ein Gleichspannungsnetz oder um ein Wechselspannungsnetz handeln. Zwischen einer Energiequelle 7 und einem elektrischen Verbraucher 6 ist der elektronische Schalter 1 zum Schutz des elektrischen Verbrauchers 6 angeordnet. Hierbei handelt es sich um einen einpoligen elektronischen Schalter 1. Allerdings kann auch ein zweipoliger elektronischer Schalter 1 verwendet werden, wie dieser in der FIG 2 dargestellt ist. Ebenso können auch mehrere elektrische Verbraucher 6 oder ein elektrisches Teilnetz an den verbraucherseitigen Anschlüssen 33, 34 des elektronischen Schalters 1 angeordnet sein.

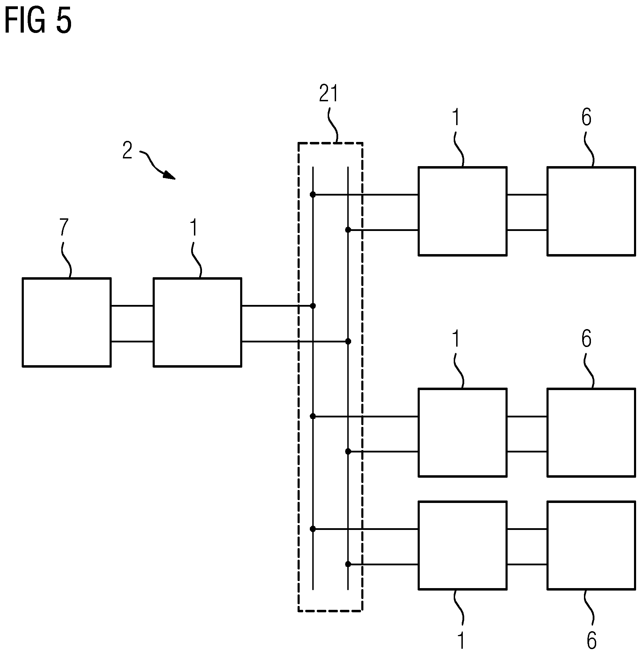

Die FIG 5 zeigt ein solches Ausführungsbeispiel eines elektrischen Netzes 2 mit mehreren elektronischen Schaltern 1. Diese elektronischen Schalter 1 können jeweils einpolig oder zweipolig ausgeführt sein. Ein erster elektronischer Schalter 1 auf der linken Seite der Darstellung dient zur Trennung der Energiequelle 7 vom elektrischen Teilnetz 21. An dem elektrischen Teilnetz 21 wiederum ist eine Vielzahl von elektrischen Verbrauchern 6 angeschlossen. Dabei kann jeder dieser elektrischen Verbraucher 6 über einen elektronischen Schalter 1 von dem elektrischen Teilnetz 21 und somit von der Energiequelle 7 getrennt werden. Alternativ ist es auch möglich, für eine Gruppe von elektrischen Verbrauchern 6, d.h. für mindestens zwei elektrische Verbraucher 6, einen elektronischen Schalter 1 als Schutzorgan vorzusehen.

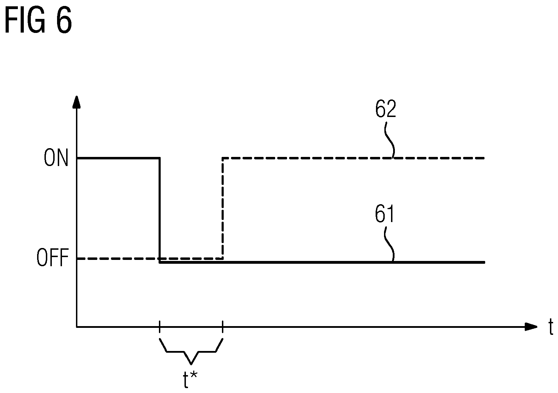

Die FIG 6 zeigt den zeitlichen Verlauf eines Ansteuersignals 61 für den Halbleiterschalter 3 und eines Ansteuersignals 62 für den Schalter 4. Zwischen dem Ausschalten des Halbleiterschalters 3 wird ein zeitlicher Verzug t* eingeführt, nach dessen Ablauf der Schalter 4 eingeschaltet wird. Während der Zeitdauer des zeitlichen Verzugs t* kann beispielsweise ein Abschaltversagen des Halbleiterschalters zuverlässig erkannt werden, dass ein Einschalten des Schalters 4 erforderlich macht. Falls der Schalter 4 unabhängig vom Erkennen eines Abschaltversagens eingeschaltet werden soll, kann auch der zeitliche Verzug t* zu null gewählt werden.

Zusammenfassend betrifft die Erfindung einen elektronischen Schalter, wobei der elektronische Schalter einen Halbleiterschalter, einen ersten verbraucherseitigen Anschluss, einen ersten quellenseitigen Anschluss und einen zweiten quellenseitigen Anschluss aufweist, wobei der Halbleiterschalter zwischen dem ersten quellenseitigen Anschluss und dem ersten verbraucherseitigen Anschluss angeordnet ist. Zur Verbesserung des elektronischen Schalters hinsichtlich seines Abschaltverhaltens im Fehlerfall wird vorgeschlagen, dass der Halbleiterschalter derart ausgebildet ist, bei Überlastung durch Überschreiten eines zulässigen Stromwertes in den geöffneten Zustand überzugehen, wobei zwischen dem ersten verbraucherseitigen Anschluss und dem zweiten quellenseitigen Anschluss ein Schalter angeordnet ist. Mit anderen Worten betrifft die Erfindung zusammenfassend einen elektronischen Schalter, wobei der elektronische Schalter einen Halbleiterschalter, einen ersten verbraucherseitigen Anschluss, einen ersten quellenseitigen Anschluss und einen zweiten quellenseitigen Anschluss aufweist, wobei der Halbleiterschalter zwischen dem ersten quellenseitigen Anschluss und dem ersten verbraucherseitigen Anschluss angeordnet ist. Zur Verbesserung des elektronischen Schalters hinsichtlich seines Abschaltverhaltens im Fehlerfall wird vorgeschlagen, dass zwischen dem ersten verbraucherseitigen Anschluss und dem zweiten quellenseitigen Anschluss ein Schalter angeordnet ist, wobei der Halbleiterschalter derart ausgebildet ist, durch Auswirkung eine thermische Überlastung im Innern des Halbleiterschalters nichtreversibel in den geöffneten Zustand überzugehen, wobei der Schalter dazu eingerichtet ist, die thermische Überlastung durch Schließen des Schalters und sich damit ausbildenden Kurzschlussstrom zu erzeugen. Die Erfindung betrifft weiter ein elektrisches Netz mit einer Energiequelle und mindestens einem derartigen elektronischen Schalter, wobei der erste quellenseitige Anschluss und der zweite quellenseitige Anschluss des elektronischen Schalters mit der Energiequelle verbunden sind. Ferner betrifft die Erfindung ein Verfahren zum Betreiben eines derartigen elektronischen Schalters oder eines derartigen elektrischen Netzes, wobei der Schalter geschlossen wird, wenn der Halbleiterschalter und/oder der weitere Halbleiterschalter abgeschaltet wird.

## Patentansprüche

1. Elektronischer Schalter (1) aufweisend
- einen Halbleiterschalter (3),
- einen ersten verbraucherseitigen Anschluss (33)
- einen ersten quellenseitigen Anschluss (31) und einen zweiten quellenseitigen Anschluss (32),
wobei der Halbleiterschalter (3) zwischen dem ersten quellenseitigen Anschluss (31) und dem ersten verbraucherseitigen Anschluss (33) angeordnet ist, wobei zwischen dem ersten verbraucherseitigen Anschluss (33) und dem zweiten quellenseitigen Anschluss (32) ein Schalter (4) angeordnet ist,
wobei der Halbleiterschalter (3) derart ausgebildet ist, durch Auswirkung einer thermischen Überlastung im Innern des Halbleiterschalters (3) und eine damit einhergehenden Veränderung des Halbleiterschalters (3) nichtreversibel in den geöffneten Zustand überzugehen, wobei der Schalter (4) dazu eingerichtet ist, die thermische Überlastung durch Schließen des Schalters (4) und sich damit ausbildenden Kurzschlussstrom zu erzeugen, **dadurch gekennzeichnet, dass** der Schalter (4) als Thyristor ausgebildet ist.

2. Elektronischer Schalter (1) nach Anspruch 1, wobei der Halbleiterschalter (3) in Modulbauweise derart ausgebildet ist, dass der nichtreversible Übergang in den geöffneten Zustand durch Schmelzen von Bonddrähten geschieht.

3. Elektronischer Schalter (1) nach einem der Ansprüche 1 oder 2, wobei der elektronische Schalter (1) einen weiteren Halbleiterschalter (5) und einen zweiten verbraucherseitigen Anschluss (34) aufweist, wobei der weitere Halbleiterschalter (5) zwischen dem zweiten quellenseitigen Anschluss (32) und dem zweiten verbraucherseitigen Anschluss (34) angeordnet ist.

4. Elektronischer Schalter (1) nach Anspruch 3, wobei der Schalter (4) zwischen dem ersten verbraucherseitigen Anschluss (33) und dem zweiten verbraucherseitigen Anschluss (34) angeordnet ist.

5. Elektronischer Schalter (1) nach einem der Ansprüche 1 bis 4, wobei der Halbleiterschalter (3) und/oder der weitere Halbleiterschalter (3) Bonddrähte aufweist.

6. Elektrisches Netz (2) mit einer Energiequelle (7) und mindestens einem elektronischen Schalter (1) nach einem der Ansprüche 1 bis 5, wobei der erste quellenseitige Anschluss (31) und der zweite quellenseitige Anschluss (32) des elektronischen Schalters (1) mit der Energiequelle (7) verbunden sind.

7. Elektrisches Netz (2) nach Anspruch 6, wobei das elektrische Netz als Gleichspannungsnetz oder Wechselspannungsnetz, insbesondere als Drehstromnetz, ausgebildet ist.

8. Elektrisches Netz (2) nach einem der Ansprüche 6 oder 7, wobei das elektrische Netz (2) mindestens einen elektrischen Verbraucher (6) aufweist.

9. Verfahren zum Betreiben eines elektronischen Schalters (1) nach einem der Ansprüche 1 bis 5 oder eines elektrischen Netzes (2) nach einem der Ansprüche 6 bis 8, wobei der Schalter (4) geschlossen wird, wenn der Halbleiterschalter (3) und/oder der weitere Halbleiterschalter (5) abgeschaltet wird, wobei das Schließen des Schalters (4) zeitgleich zum Zeitpunkt des Abschaltens des Halbleiterschalters (3) und/oder des weiteren Halbleiterschalters (5) erfolgt.

## Claims

1. Electronic switch (1) having
- a semiconductor switch (3),
- a first consumer-side terminal (33),
- a first source-side terminal (31) and a second source-side terminal (32),
wherein the semiconductor switch (3) is arranged between the first source-side terminal (31) and the first consumer-side terminal (33), wherein a switch (4) is arranged between the first consumer-side terminal (33) and the second source-side terminal (32),
wherein the semiconductor switch (3) is embodied such that it irreversibly transitions into the opened state due to the effect of a thermal overload inside the semiconductor switch (3) and an associated modification of the semiconductor switch (3), wherein the switch (4) is configured to generate the thermal overload by way of closing the switch (4) and the short-circuit current that forms as a result, **characterised in that** the switch (4) is embodied as a thyristor.

2. Electronic switch (1) according to claim 1, wherein the semiconductor switch (3) is embodied in a modular construction, such that the irreversible transition into the opened state takes place by melting bonding wires.

3. Electronic switch (1) according to one of claims 1 or 2, wherein the electronic switch (1) has a further semiconductor switch (5) and a second consumer-side terminal (34), wherein the further semiconductor switch (5) is arranged between the second source-side terminal (32) and the second consumer-side terminal (34).

4. Electronic switch (1) according to claim 3, wherein the semiconductor switch (4) is arranged between the first consumer-side terminal (33) and the second consumer-side terminal (34).

5. Electronic switch (1) according to one of claims 1 to 4, wherein the semiconductor switch (3) and/or the further semiconductor switch (3) has bonding wires.

6. Electrical network (2) with an energy source (7) and at least one electronic switch (1) according to one of claims 1 to 5, wherein the first source-side terminal (31) and the second source-side terminal (32) of the electronic switch (1) are connected to the energy source (7).

7. Electrical network (2) according to claim 6, wherein the electrical network is embodied as a DC voltage network or AC voltage network, in particular as a three-phase network.

8. Electrical network (2) according to one of claims 6 or 7, wherein the electrical network (2) has at least one electrical consumer (6).

9. Method for operating an electronic switch (1) according to one of claims 1 to 5 or an electrical network (2) according to one of claims 6 to 8, wherein the switch (4) is closed if the semiconductor switch (3) and/or the further semiconductor switch (5) is turned off, wherein the switch (4) is closed at the same time as the point in time of turning off the semiconductor switch (3) and/or the further semiconductor switch (5).

## Revendications

1. Interrupteur (1) électronique comportant
- un interrupteur (3) à semiconducteur,
- une première borne (33) du côté du consommateur,
- une première borne (31) du côté de la source et une deuxième borne (32) du côté de la source,
dans lequel l'interrupteur (3) à semiconducteur est monté entre la première borne (31) du côté de la source et la première borne (33) du côté du consommateur, dans lequel un interrupteur (4) est monté entre la première borne (33) du côté du consommateur et la deuxième borne (32) du côté de la source,
dans lequel l'interrupteur (3) à semiconducteur est constitué de manière, par l'effet d'une surcharge thermique à l'intérieur de l'interrupteur (3) à semiconducteur et d'une modification s'en suivant ainsi de l'interrupteur (3) à semiconducteur, à passer irréversiblement à l'état ouvert, dans lequel l'interrupteur (4) est conçu pour produire la surcharge thermique par fermeture de l'interrupteur (4) et le courant de court-circuit, qui se constitue ainsi,
**caractérisé en ce que**
l'interrupteur (4) est constitué sous la forme d'un thyristor.

2. Interrupteur (1) électronique suivant la revendication 1, dans lequel l'interrupteur (3) à semiconducteur est constitué en mode de construction modulaire, de manière à ce que le passage irréversible à l'état ouvert s'effectue par fusion de fils de liaison.

3. Interrupteur (1) électronique suivant l'une des revendications 1 ou 2, dans lequel l'interrupteur (1) électronique a un autre interrupteur (5) à semiconducteur et une deuxième borne (34) du côté du consommateur, dans lequel l'autre interrupteur (5) à semiconducteur est monté entre la deuxième borne (32) du côté de la source et la deuxième borne (34) du côté du consommateur.

4. Interrupteur (1) suivant la revendication 3, dans lequel l'interrupteur (4) est monté entre la première borne (33) du côté du consommateur et la deuxième borne (34) du côté du consommateur.

5. Interrupteur (1) suivant l'une des revendications 1 à 4, dans lequel l'interrupteur (3) à semiconducteur et/ou l'autre interrupteur (3) à semiconducteur a des fils de liaison.

6. Réseau (2) électrique comprenant une source (7) d'énergie et au moins un interrupteur (1) électronique suivant l'une des revendications 1 à 5, dans lequel la première borne (31) du côté de la source et la deuxième borne (32) du côté de la source de l'interrupteur (1) électronique sont reliées à la source (7) d'énergie.

7. Réseau (2) électrique suivant la revendication 6, dans lequel le réseau électrique est constitué sous la forme d'un réseau à tension continue ou d'un réseau à tension alternative, notamment sous la forme d'un réseau à courant triphasé.

8. Réseau (2) électrique suivant l'une des revendications 6 ou 7, dans lequel le réseau (2) électrique a au moins un consommateur (6) électrique.

9. Procédé pour faire fonctionner un interrupteur (1) électronique suivant l'une des revendications 1 à 5 ou un réseau (2) électrique suivant l'une des revendications 6 à 8, dans lequel on ferme l'interrupteur (4), si on ouvre l'interrupteur (3) à semiconducteur et/ou l'autre interrupteur (5) à semiconducteur, la fermeture de l'interrupteur (4) s'effectuant au même instant que l'ouverture de l'interrupteur (3) à semiconducteur et/ou de l'autre interrupteur (5) à semiconducteur.
